(19) **Europäisches Patentamt European Patent Office Office européen des brevets**

(11) **EP 2 050 121 B1**

(12) **FASCICULE DE BREVET EUROPEEN**

(45) Date de publication et mention de la délivrance du brevet:
**06.03.2013 Bulletin 2013/10**

(21) Numéro de dépôt: **07823679.1**

(22) Date de dépôt: **02.08.2007**

(51) Int Cl.:
***H01J 37/34*** *(2006.01)*

(86) Numéro de dépôt international:
**PCT/FR2007/051768**

(87) Numéro de publication internationale:
**WO 2008/017780 (14.02.2008 Gazette 2008/07)**

(54) **PROCÉDÉ ET DISPOSITIF POUR LE DÉPÔT DE COUCHE BARRIÈRE PAR PLASMA FROID ET MACHINE UTILISANT UN TEL DISPOSITIF**

VERFAHREN UND VORRICHTUNG ZUR KALTPLASMA-ABLAGERUNG EINER ABGRENZUNGSSCHICHT UND MASCHINE MIT EINER SOLCHEN VORRICHTUNG

METHOD AND DEVICE FOR THE COLD-PLASMA DEPOSITION OF A BOUNDARY LAYER AND MACHINE USING SUCH A DEVICE

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **07.08.2006 FR 0653304**

(43) Date de publication de la demande:
**22.04.2009 Bulletin 2009/17**

(73) Titulaire: **Sidel Participations
76930 Octeville Sur Mer (FR)**

(72) Inventeurs:
• **CHOMEL, Nicolas
F-76930 Octeville S/mer (FR)**
• **BOUTROY, Naïma
F-76930 Octeville S/mer (FR)**
• **CETINEL, Ertan
F-76930 Octeville Sur Mer (FR)**

(74) Mandataire: **Cabinet Plasseraud
52, rue de la Victoire
75440 Paris Cedex 09 (FR)**

(56) Documents cités:
**EP-A- 1 106 709    EP-A- 1 580 298**

**Description**

La présente invention concerne un procédé et un dispositif de contrôle d'un générateur d'alimentation haute tension pour magnétron en vue du dépôt d'une couche barrière par plasma froid. Elle concerne aussi une machine de dépôt de couche barrière par plasma froid utilisant un tel dispositif.

Dans l'état de la technique, on a déjà décrit des procédés qui, suite à l'injection de précurseurs gazeux, ou encore de mélanges gazeux, par exemple à base de carbone et/ou de silicium, à l'intérieur de corps creux en matériau plastique comme du PET, permettent de produire un plasma froid conduisant à la formation de couches barrière. Ces couches sont particulièrement appropriées lorsque les corps creux sont des récipients : en effet, elles permettent de protéger le contenu, ultérieurement rempli dans le récipient, des échanges gazeux avec l'extérieur, notamment de l'oxygène de l'air. Une telle protection est particulièrement avantageuse par exemple, mais non exclusivement, lorsque le produit rempli dans le récipient est un produit alimentaire.

Dans l'état de la technique, de tels procédés sont mis en oeuvre au moyen de machines de dépôt de couche barrière par plasma froid comprenant au moins un poste de traitement avec une cavité et un magnétron produisant des micro-ondes. Au moins un corps creux à traiter est introduit dans la cavité et l'énergie micro-ondes, qui est appliquée en un emplacement convenable du volume intérieur du corps creux comprenant du gaz précurseur, préalablement injecté, produit un plasma froid dont les espèces actives sont projetées contre la paroi du corps creux. L'ensemble de ces espèces actives forme le dépôt barrière aux échanges gazeux entre l'intérieur et l'extérieur du corps creux.

Le document EP 1106 709 A2 montre un procédé de contrôle d'un générateur d'alimentation électrique haute tension pour magnétron destiné à produire un plasma froid à l'intérieur d'un corps creux de façon à déposer une couche barrière à l'intérieur dudit corps creux, le procédé comportant un choix du mode de fonctionnement du générateur parmi une pluralité de modes de fonctionnement.

Cependant, les dispositifs destinés à générer l'alimentation électrique du magnétron, qui transforme l'énergie électrique qu'il reçoit en une énergie micro-ondes qu'il rayonne, ne présentent pas dans l'état de la technique une performance optimisée pour un tel dépôt d'une couche barrière interne.

Pour parvenir à des cadences de production élevées, il est connu que les machines de dépôt de couches barrière comportent plusieurs postes de travail (jusqu'à 48 sur les machines connues jusqu'alors) comprenant chacun au moins un magnétron ou une antenne rayonnante connectée à un magnétron. Il en résulte que la panne d'un seul de ces magnétrons entraîne des pertes de production. De plus, une mauvaise définition de l'alimentation électrique du magnétron (forme d'onde de puissance) limite la performance du processus ainsi que la durée de vie de ce magnétron.

La présente invention apporte remède à ces inconvénients de l'état de la technique en ce qu'elle concerne un procédé de contrôle d'un générateur d'une alimentation électrique haute tension pour magnétron destiné à produire un plasma froid à l'intérieur d'un corps creux de façon à déposer une couche barrière à l'intérieur du corps creux.

Selon un premier de ses aspects, la présente invention porte sur un procédé de contrôle d'un générateur d'alimentation électrique haute tension pour magnétron destiné à produire un plasma froid à l'intérieur d'un corps creux de façon à déposer une couche barrière à l'intérieur dudit corps creux, caractérisé en ce qu'il consiste à choisir un mode de fonctionnement du générateur parmi une pluralité de modes de fonctionnement, la modification du mode de fonctionnement du générateur faisant varier au moins un coefficient définissant une puissance maximale $P_{max}$ de la forme d'onde de la puissance d'alimentation du magnétron en fonction d'une puissance moyenne de consigne $P_{moy}$ du magnétron, la forme d'onde d'alimentation du magnétron étant répétée dans une récurrence avec un rapport cyclique de conduction Th dépendant de la puissance moyenne de consigne $P_{moy}$ et/ou de la puissance maximale $P_{max}$.

Avantageusement, la puissance maximale $P_{max}$ de la forme d'onde est prédéterminée en fonction de la puissance de consigne $P_{moy}$.

Selon une première forme de réalisation d'un mode de fonctionnement du procédé selon l'invention, ladite relation entre la puissance moyenne $P_{moy}$ et la puissance maximale $P_{max}$ est de la forme polynomiale $P_{max}= a*(P_{moy})^n + b*(P_{moy})^{n-1} + C*(P_{moy})^{n-2} +... + k*(P_{moy})^{n-p}$, avec n et p des nombres entiers, n étant supérieur ou égal à p, et (a, b, c,...k) étant des coefficients variables.

Avantageusement, ladite relation polynomiale est de forme parabolique $P_{max} =a*(P_{moy})^2+b*P_{moy} +c$ avec a, b, c étant des coefficients variables.

Préférentiellement, le rapport cyclique de conduction Th, en pourcentage, est déterminé par la relation $Th=100*P_{moy}*\pi/(2*P_{max})$.

Selon une seconde forme de réalisation d'un mode de fonctionnement du procédé selon l'invention, le rapport cyclique de conduction Th, en pourcentage, est dépendant de la puissance moyenne de consigne $P_{moy}$ par la relation polynomiale de formule $Th=a1*(Pmoy)^n+b1*(P_{moy})^{n-1}+c1*(P_{moy})^{n-2}+...+k1*(P_{moy})^{n-p}$, avec n et p des nombres entiers, n étant supérieur ou égal à p, et (a1, b1, c1,...k1), étant des coefficients variables.

Avantageusement, ladite relation polynomiale est de forme parabolique $Th=a1(P_{moy})^2+b1*P_{moy}+c1$ avec a1, b1, c1 étant des coefficients variables.

Préférentiellement, la puissance maximale $P_{max}$ est déterminé par la relation $P_{max}=\pi*P_{moy}/(2*Th)$.

De manière avantageuse, dans un mode de fonctionnement, aucun des coefficients n'est nul.

Alternativement, dans un autre mode de fonctionnement, au moins deux coefficients sont nuls.

Plus précisément, dans un mode de fonctionnement, la puissance maximale $P_{max}$ est fixée constante.

De même, le rapport cyclique Th est linéairement dépendant de la puissance moyenne $P_{moy}$.

De manière avantageuse, la puissance maximale est déterminée et apte à varier sur la base d'une surface de sécurité limitée par une valeur maximale admissible de la puissance maximale $P_{max, max}$ pour le magnétron et une valeur inférieure de la puissance maximale $P_{max, min}$ déterminée par un rapport cyclique de conduction maximum $Th_{max}$ donné par la conception du magnétron et de son alimentation.

Avantageusement, encore dans un mode de fonctionnement, la puissance maximale $P_{max}$ est linéairement dépendante de la valeur de la puissance de consigne moyenne $P_{moy}$.

Toujours dans un autre mode de fonctionnement, le rapport cyclique de conduction Th est fixe.

Toujours dans le même autre mode de fonctionnement, le rapport cyclique de conduction Th de la forme d'onde est déterminé et apte à être choisi sur la base d'une surface de sécurité limitée par une valeur du rapport cyclique de conduction maximale admissible $Th_{max}$ et une valeur inférieure du rapport cyclique de conduction minimale $Th_{min}$ déterminée en fonction de la limitation supérieure de la puissance maximale admise $P_{max, max}$ qui dépend des caractéristiques du magnétron et de son alimentation.

De manière avantageuse, lesdits coefficients sont déterminés par des essais de traitement d'un lot de corps creux dont on tire une relation entre la puissance moyenne de consigne $P_{moy}$, la puissance maximale $P_{max}$ et le rapport cyclique de conduction Th.

Avantageusement, le coefficient a est compris entre (-0.0020) et 0.0020, en ce que le coefficient b est compris entre 0 et 4, et en ce que le coefficient c est compris entre 0 et 3000.

Selon un second de ses aspects, la présente invention porte sur un dispositif de contrôle d'un générateur d'alimentation haute tension pour magnétron de dépôt de couche barrière par plasma froid de l'invention, du genre comportant :

- un circuit pour piloter un générateur d'alimentation haute tension;
- un circuit pour contrôler les électrodes de commande d'un pont d'interrupteurs de puissance en fonction d'une forme d'onde de puissance de consigne, ledit dispositif de contrôle mettant en ouvre le procédé tel que précédemment mentionné et comportant :
- des moyens pour mémoriser des paramètres de puissance maximale, de conduction en fonction d'un mode de fonctionnement prédéterminé,
- un moyen pour sélectionner une valeur de consigne de puissance moyenne $P_{moy}$,
- un moyen pour déterminer une fréquence de fonctionnement,
- un moyen pour sélectionner un mode de fonctionnement du générateur, et
- un moyen pour déterminer toutes les caractéristiques de consigne instantanées définissant l'onde de puissance assurant un objectif de travail exprimé en termes de performance du dépôt créé sur le corps creux et le respect de son intégrité en maîtrisant son échauffement lors du dépôt.

Selon un troisième de ses aspects, la présente invention porte sur une machine de dépôt de couche barrière sur la paroi intérieure d'un corps creux en matériau plastique, du type bouteille, à l'aide d'un plasma froid excité par un magnétron, alimenté par un générateur haute tension, contrôlé par un dispositif de contrôle tel que mentionné ci-dessus.

D'autres caractéristiques et avantages de la présente invention seront mieux compris à l'aide de la description d'un exemple uniquement illustratif et nullement limitatif de la portée de l'invention, et à partir des figures annexées parmi lesquelles :

-- la figure 1 est une représentation schématique comportant trois parties, respectivement 1 a, 1b, 1c, pour illustrer un dispositif de contrôle d'un générateur d'alimentation électrique haute tension destiné à l'alimentation de magnétrons pour une machine de dépôt de couche barrière par plasma froid, le plasma froid étant induit par le rayonnement micro-ondes du magnétron alimenté ;

-- la figure 2 représente deux exemples d'onde de puissance instantanée ;

-- la figure 3 représente un organigramme d'un mode de réalisation du procédé de l'invention ;

-- les figures 4a et 4b représentent deux fonctions illustrant respectivement la variation de la puissance maximale $P_{max}$ en fonction de la puissance moyenne $P_{moy}$ et la variation du rapport cyclique de conduction Th en fonction de la puissance moyenne $P_{moy}$ permettant de déterminer l'alimentation électrique du magnétron selon deux alternatives d'un premier mode de fonctionnement du générateur d'alimentation électrique selon l'invention (MODE 1) ;

-- la figure 5 représente une surface de sécurité, dans laquelle peut varier la puissance maximale $P_{max}$ de la forme d'onde d'alimentation du magnétron, en fonction de la puissance moyenne permettant de déterminer l'alimentation électrique du magnétron dans un second mode de fonctionnement du générateur d'alimentation électrique selon l'invention (MODE 2);

-- la figure 6 représente une surface de sécurité, dans laquelle peut être choisi le rapport cyclique de conduction Th de la forme d'onde d'alimentation du magnétron, en fonction de la puissance moyenne permettant de déterminer une forme d'onde d'alimentation électrique du magnétron dans un troisième mode de fonctionnement du générateur d'alimentation électrique selon l'invention (MODE 3) ;

-- la figure 7 représente un circuit permettant de commuter entre plusieurs modes de fonctionnement du générateur d'alimentation électrique pour la détermination de les caractéristiques de l'onde de puissance du magnétron ;

-- la figure 8 est une représentation schématique d'une forme d'onde obtenue à l'aide du premier mode de fonctionnement du générateur ;

-- la figure 9 est une représentation schématique d'une forme d'onde obtenue à l'aide du deuxième mode de fonctionnement du générateur ;

-- la figure 10 est une représentation schématique d'une forme d'onde obtenue à l'aide du troisième mode de fonctionnement du générateur ;

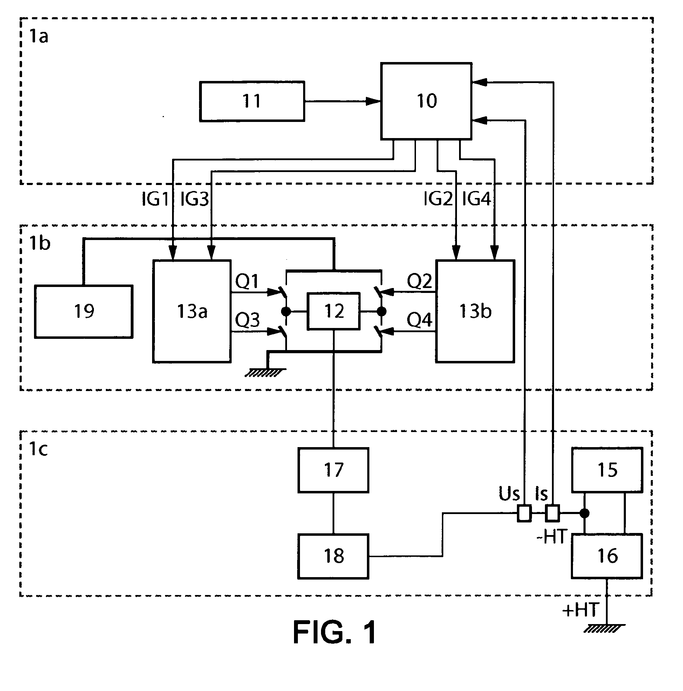

À la figure 1, on a représenté de manière schématique un dispositif de contrôle de l'alimentation d'un générateur d'alimentation électrique haute tension pour un magnétron, ledit dispositif de contrôle selon l'invention comprenant :

-- dans une première partie 1 a : un organe de traitement et pilotage d'un dispositif de contrôle d'un générateur d'alimentation haute tension pour magnétron ;

-- dans une seconde partie 1b : la partie convertisseur d'énergie et

-- dans une troisième partie 1c : la partie haute tension de l'alimentation et de mesures de courant et tension du magnétron 16.

Le dispositif de contrôle de l'invention comporte un organe 1a de traitement représenté dans la partie 1a construit autour d'un microcontrôleur 10 qui reçoit au moins deux signaux de mesure et un signal de consigne, à savoir :

-- un signal de mesure du courant Is, image du courant alimentant l'anode du magnétron 16, délivré par la partie 1c, le magnétron 16, et plus précisément son filament, est alimenté en courant par un transformateur 15 ;

-- un signal de mesure de la tension Us, image de la tension d'alimentation entre l'anode du magnétron 16 entre l'alimentation provenant du circuit 1c et la masse ;

-- un signal de consigne $P_{moy}$ (consigne de puissance moyenne) fourni par un organe 11 de détermination de la puissance de consigne.

Le dispositif de contrôle de l'invention est mis en oeuvre sous la forme d'un programme enregistré dans la mémoire du microcontrôleur 10, un mode de réalisation du procédé de contrôle selon l'invention, adapté au générateur d'alimentation haute tension pour magnétron 16 étant décrit de manière plus précise ultérieurement. Le programme enregistré, lorsqu'il est exécuté notamment par le circuit «DSP» du microcontrôleur 10 du dispositif de contrôle comprenant les parties 1a à 1c, détecte périodiquement la valeur de consigne moyenne $P_{moy}$ fournie par l'organe 11 ainsi que les valeurs de mesures du courant Is et de la tension Us et détermine quatre signaux de commande respectivement IG1 à IG4 à destination de deux circuits de pilotage 13a et 13b d'interrupteurs de puissance Q1 à Q4 qui vont moduler l'énergie fournie par l'alimentation 19 utilisant la technologie MLI (Modulation à Largeur d'Impulsion). Le transfert d'énergie est réalisé par le circuit 12 qui est constitué d'un filtre à résonance. La modulation, pilotée par les circuits 13a et 13b, est effectuée par des interrupteurs de puissance Q1 à Q4 capables de commuter des puissances importantes en haute fréquence. La partie primaire du transformateur haute tension est intégrée dans le circuit résonnant 12,

Il est déjà connu de l'état de la technique, de réaliser des dispositifs permettant de déposer une couche barrière sur des corps creux en matériau plastique à l'aide d'un plasma froid amorcé et entretenu à l'aide d'un magnétron produisant un rayonnement micro-ondes, lorsqu'un précurseur gazeux convenable (gaz simple ou mélange de gaz) a été introduit à l'intérieur du corps creux en matériau plastique. Le magnétron doit être connecté à un générateur de haute tension. Afin de transformer la tension alternative produite dans la partie 1b (à savoir la partie convertisseur à résonance) en une tension alternative haute tension, il est connu d'utiliser un transformateur rehausseur haute tension 17 dont le circuit primaire intégré dans le filtre 12 est connecté dans la branche de courant située entre les quatre interrupteurs de puissance Q1 à Q4, et dont le secondaire est connecté sur un pont redresseur haute tension 18, par exemple constitué de quatre diodes montées de la manière connue (tel qu'un pont de Graetz). Par ailleurs, pour réaliser un filtrage de façon à adapter les valeurs maximales de l'onde haute tension délivrée en sortie du pont redresseur 18, il est connu d'utiliser des bobines à noyau magnétique (non représentées) pour assurer le filtrage du courant aux bornes du magnétron 16.

En aval du filtrage est connecté le magnétron 16, via les connexions «haute tension négative» -HT et «haute tension positive» +HT, utilisées pour connecter les électrodes de masse «haute tension» et de filament « haute tension ».

Une troisième connexion de chauffage de filaments est aussi prévue, et l'alimentation «haute tension négative» -HT ainsi que la tension de chauffage de filaments sont fournies par un transformateur 15 d'alimentation adapté au magnétron 16. La borne «haute tension positive» +HT est connectée à la masse haute tension du dispositif de l'invention.

En dérivation sur les deux bornes «haute tension négative» et «haute tension positive» du générateur d'alimentation haute tension, est disposé un circuit de mesure de la tension instantanée qui permet de mesurer le potentiel «haute tension négative» Us, image de la tension d'alimentation entre l'anode du magnétron 16 et sa masse, sous lequel est alimenté le magnétron 16 et dont la mesure instantanée permet de représenter l'énergie micro-ondes radiante qui est appliquée de façon à exciter les espèces moléculaires dans le gaz et entretenir le plasma froid, générateur de la couche barrière.

Par ailleurs, la mesure du courant Is, image du courant alimentant l'anode du magnétron 16, délivré par la partie 1b convertisseur à résonance, est effectuée en sortie du pont redresseur haute tension 18.

Il en résulte que le contrôle précis du courant délivré par la partie convertisseur 1b à résonance ainsi que de la tension appliquée au magnétron 16 permet de produire une représentation de la puissance instantanée absorbée par le magnétron 16. Grâce à une relation déterminée de la conversion de l'énergie électrique en énergie micro-onde effectuée par le magnétron 16, il est possible de contrôler l'état du plasma froid généré dans le précurseur gazeux introduit.

Lors d'une étape préalable, on détermine lors de nombreux tests, les caractéristiques optimales de l'onde (forme, fréquence, valeur crête) de puissance à appliquer au magnétron 16 de façon à produire une couche barrière correcte sans chauffer excessivement le corps creux en matière plastique. En effet, il est indispensable de générer une couche barrière avec des caractéristiques précises tout en maîtrisant l'échauffement de la paroi en matériau plastique du corps creux, afin de ne pas le déformer ou modifier son aspect. Il en résulte que c'est grâce à la maîtrise des caractéristiques définissant l'onde ainsi que des pressions sous lesquelles le mélange gazeux est distribué dans le corps creux que l'on parvient à réaliser une couche barrière correcte. Pour rendre plus facile et mieux contrôlable la production d'une onde d'alimentation haute tension du magnétron en vue d'obtenir des corps creux correctement recouverts d'une couche barrière homogène sans qu'ils soient soumis à une température trop élevée du plasma froid, et afin que le dépôt présente une couche avec les propriétés barrière souhaitées notamment liées à son homogénéité et son épaisseur, l'invention propose un procédé pour générer une onde de puissance contrôlée selon une pluralité de modes de fonctionnement, ce grâce à quoi il est possible de changer facilement d'un mode de génération d'une forme d'onde d'alimentation du magnétron en fonction des caractéristiques du corps creux et du gaz injecté et de choisir un mode de fonctionnement optimal du générateur en fonction de plusieurs caractéristiques d'une forme générique d'une onde d'alimentation du magnétron

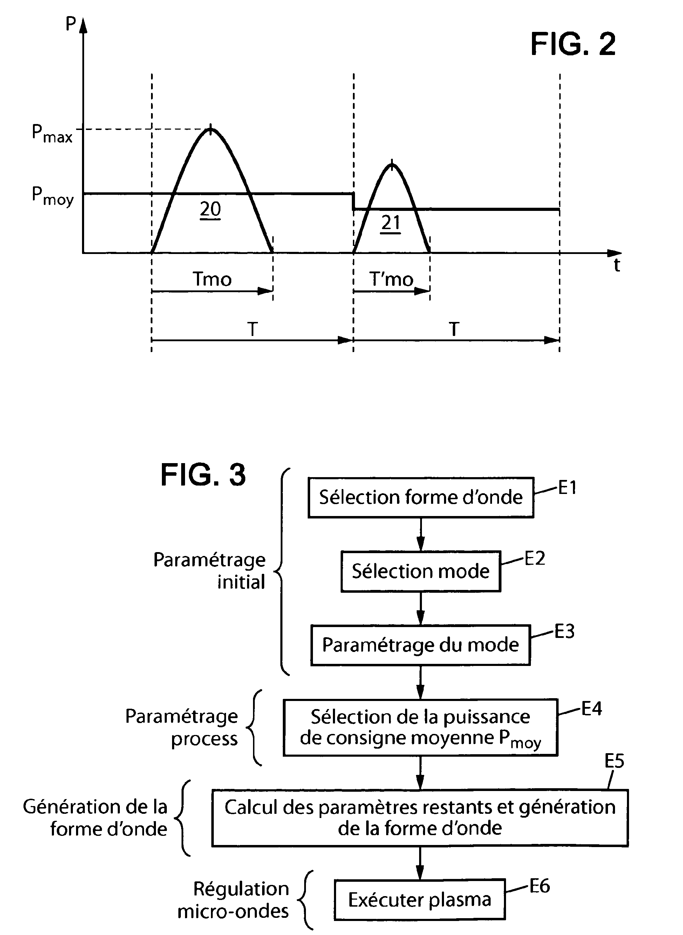

À la figure 2, on a représenté un chronogramme d'une succession de deux formes d'onde 20 et 21 dans un mode particulier de réalisation de l'invention. On a représenté en abscisse l'axe des temps et en ordonnée l'axe des puissances instantanées P. Selon le procédé de l'invention, il est possible de paramétrer les caractéristiques d'amplitude maximale, à savoir la puissance d'alimentation maximale $P_{max}$, de durée active Tmo, de période de récurrence T liées par le rapport cyclique de conduction Th = Tmo/T, d'une forme d'onde se présentant la forme d'une arche de sinusoïde positive. Il est bien entendu que d'autres formes d'onde sont aussi concernées par le procédé de l'invention, par exemple une forme d'onde du type triangulaire en pic ou du type en crête.

De manière générale, le rapport cyclique de conduction Th est défini par le rapport Th = Tmo / T, Tmo étant le temps actif de l'onde élémentaire, et T la période de récurrence. La moyenne de la puissance $P_{moy}$ est alors définie sur la période T. Elle est obtenue en calculant la puissance moyenne de 0 à T $Pmoy = \dfrac{1}{T}\int_0^T P(t)dt$ ce qui donne

dans le cas d'une onde sous la forme d'une arche de sinusoïde : $Pmoy = \dfrac{2.P\max .Th}{\pi}$

Le procédé de l'invention permet de choisir la forme d'onde, son rapport cyclique de conduction Th ainsi que son pourcentage de modification (autrement dit sa transformation homothétique) d'une récurrence à une autre de façon à s'adapter à des objectifs de traitement par dépôt de couche barrière déterminés en termes de coloration du corps creux traité, de température de corps creux lors de l'application du plasma micro-ondes, et en terme de régularité de la couche barrière, la régularité étant exprimée notamment en terme d'épaisseur de dépôt.

Ainsi, sur la figure 2, il est représenté l'évolution au cours du temps t de la puissance P d'alimentation du magnétron formant ainsi deux exemples d'ondes en arche de sinusoïde et avec une diminution homothétique de l'onde d'une première forme d'onde 20 à la première récurrence de l'onde 21 pour une nouvelle consigne de puissance, la durée active Tmo étant réduite en conséquence en T'mo, alors que la période T reste constante.

Particulièrement, l'invention pose une condition prédéterminée entre la puissance moyenne de consigne $P_{moy}$, la puissance maximale $P_{max}$ et le rapport cyclique de conduction Th ou de répétition de la forme d'onde. Par exemple, dans le cas où la forme d'onde est figée pendant une durée suffisamment longue sur une forme d'onde en arche de sinusoïde une telle condition prédéterminée peut être exprimée par une relation de la forme : $P_{moy} = (2* P_{max} {}^* Th)/\pi$ dans laquelle « $\pi$» réfère à l'unité d'angle.

Dans l'exemple de réalisation de la figure 2, une première arche de sinusoïde 20 présente une durée active, Tmo, qui est une première partie d'une période T de répétition de la forme d'onde. Pour déterminer complètement cette onde destinée à alimenter le magnétron 16, il faut aussi déterminer la valeur maximale de l'enveloppe de la puissance instantanée. Pour contrôler l'énergie appliquée au plasma micro-ondes par le magnétron 16, on dispose donc notamment d'un moyen de réglage de la puissance maximum $P_{max}$ et de la durée de la première partie constituant la durée active, Tmo, d'application des micro-ondes par la forme d'onde sur la période complète T de récurrence de la forme d'onde.

Pour contrôler le fonctionnement du générateur haute tension d'alimentation du magnétron 16, on détermine un mode de fonctionnement dans lequel on se donne une valeur de consigne de puissance moyenne, qui sera désignée dans la suite de la description par la valeur $P_{moy}$, étant entendu que le dispositif de contrôle de l'invention comporte, en fonction du mode de fonctionnement retenu, un moyen pour déterminer :

-- la forme d'onde proprement dite, préférentiellement comme une forme d'onde en arche de sinusoïde,
-- les paramètres déterminant l'onde, comme le rapport cyclique de conduction Th des micro-ondes par rapport à la période de la récurrence de la forme d'onde T, et la puissance maximale $P_{max}$. L'onde est définie par sa forme (préférentiellement une demi-arche positive de sinusoïde), sa période propre et sa période de récurrence liées par le rapport de conduction Th, et la puissance maximale $P_{max}$.

Autrement dit, la présente invention propose un procédé de contrôle d'un générateur d'alimentation électrique haute tension pour magnétron 16 destiné à produire un plasma froid à l'intérieur d'un corps creux de façon à déposer une couche barrière à l'intérieur dudit corps creux, caractérisé en ce qu'il consiste à choisir un mode de fonctionnement du générateur parmi une pluralité de modes de fonctionnement, la modification du mode de fonctionnement du générateur faisant varier au moins un coefficient définissant une puissance maximale $P_{max}$ de la forme d'onde de la puissance d'alimentation du magnétron 16 en fonction d'une puissance moyenne de consigne $P_{moy}$ du magnétron 16, la forme d'onde d'alimentation du magnétron 16 étant répétée avec une récurrence de période T.

A la figure 3, on a représenté un organigramme du procédé de l'invention. Lors de l'étape E1, la forme d'onde de puissance proprement dite est choisie, préférentiellement une forme d'arche de sinusoïde. Lors de l'étape E2, est sélectionné un mode de fonctionnement parmi une pluralité de modes prédéfinis. En fonction du mode sélectionné, dans l'étape E3, il peut être nécessaire de renseigner la valeur d'un paramètre ($P_{max}$ ou Th) et vérifier que la valeur de ce paramètre est compatible avec la plage de consigne $P_{moy}$ que l'on souhaite utiliser pour l'application. Le mode de calcul des limites est défini ultérieurement (plage de fonctionnement). Avant de lancer le traitement des corps creux, un processus est défini dans l'étape E4 permettant à l'opérateur de saisir la puissance de consigne moyenne $P_{moy}$. Le dispositif de contrôle comportant un microcontrôleur 10 exécute une séquence (par exemple un programme informatique) incluant un algorithme de calcul du paramètre de la puissance maximale $P_{max}$ et/ou du paramètre du rapport cyclique de conduction Th, si nécessaire, lors de l'étape E5. L'onde respectant la puissance moyenne de consigne est alors définie. Dans un mode de réalisation, le microcontrôleur 10 comporte aussi un moyen pour déterminer la puissance de consigne instantanée permettant la régulation de l'alimentation du magnétron 16. Enfin, lors de l'étape E6, le dispositif d'alimentation du magnétron 16 piloté par le bloc 1a génère et régule suivant l'onde définie par les étapes préalables E1 à E5.

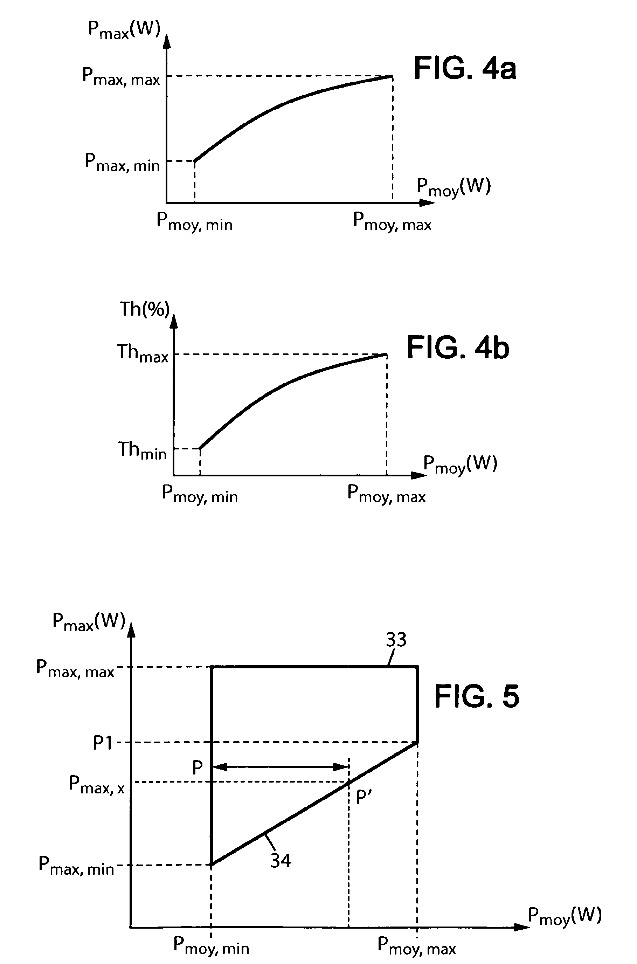

À la figure 4a, on a représenté la variation de la valeur de puissance maximum $P_{max}$ de l'onde d'alimentation du magnétron 16 en fonction de la puissance de consigne moyenne $P_{moy}$ du magnétron 16 (autrement dit la puissance consommée par le magnétron 16).

Lors de nombreux essais, en utilisant des magnétrons de puissance inférieure à 1 kW et fonctionnant pour une fréquence nominale de l'ordre de 2,45 GHz et une forme d'onde du type sinusoïdal, on a déterminé que pour une fréquence nominale la puissance maximale $P_{max}$, est correctement représentée par une section de parabole déterminée par une relation de la forme :

$$P_{max} = a*(P_{moy})^2 + b* P_{moy} + c$$

dans laquelle les constantes a, b et c sont établies à partir des essais réalisés sur une gamme significative de corps creux utilisés dans les machines de dépôt de couche barrière de l'invention.

De manière plus générale, il a pu être constaté que la relation entre la puissance moyenne $P_{moy}$ et la puissance maximale $P_{max}$ est d'une forme polynomiale $P_{max}= a*(Pmoy)^n + b*(P_{moy})^{n-1} + C*(Pmoy)^{n-2} +... + k*(P_{moy})^{n-p}$, avec n et p des nombres entiers, n étant supérieur ou égal à p, et (a, b, c,...k), étant des coefficients variables, étant entendu que la forme préférentielle de la relation est une forme parabolique.

Il est ainsi représenté sur la figure 4a une section de courbe parabolique entre deux points limites du fonctionnement du générateur selon un premier mode de fonctionnement entre un point où la puissance moyenne $P_{moy, min}$ est minimale et où la puissance maximale a une valeur limite inférieure $P_{max, min}$ et un point où la puissance moyenne est maximale $P_{moy, max}$ et où la puissance maximale a une valeur limite supérieure $P_{max, max}$.

Il a déjà été vu que le rapport cyclique de conduction pouvait être donné par la formule suivante, $Th(\%) = 100 * P_{moy} * \pi / (2 * P_{max})$ pour une forme d'onde du type sinusoïdale. De manière générale, le rapport cyclique de conduction peut être donné par une formule du type $Th = F(P_{moy})$.

Ainsi, possédant les deux courbes des caractéristiques $P_{max} = f(P_{moy})$ et $Th = F(P_{moy})$, il suffit à l'utilisateur de définir la valeur de consigne $P_{moy}$ souhaitée. Dans un mode particulier de réalisation le microcontrôleur comporte aussi un moyen pour déterminer les valeurs $P_{max}$ et $Th$ automatiquement, connaissant les autres paramètres indispensables (fréquences,..), sur la base d'une mémoire de cartographie incorporant les deux courbes précitées, variées selon lesdits paramètres indispensables. Les caractéristiques de l'onde en arche de sinusoïde à utiliser lors de la régulation des micro-ondes (alimentation du magnétron) sont ainsi calculées précisément.

Ces deux courbes de caractéristiques $f(P_{moy})$ et $F(P_{moy})$ permettent, en combinaison, d'établir un premier mode de fonctionnement assurant les objectifs décrits ci-dessus pour le corps creux et sa couche barrière déposée par plasma froid.

De manière alternative, quand le rapport cyclique de conduction $Th$ n'est pas modélisé par la relation de formule $Th(\%) = 100 * P_{moy} * \pi / (2 P_{max})$ (c'est-à-dire quand la forme d'onde n'est pas du type sinusoïdal), il est également possible de modéliser la variation du rapport cyclique de conduction $Th$ en fonction de la puissance moyenne $P_{moy}$.

Pour ce faire, lors de nombreux essais, en utilisant des magnétrons de puissance inférieure à 1 kW et fonctionnant pour une fréquence nominale de l'ordre de 2,45 GHz, il a pu être déterminé que le rapport cyclique $Th$ pouvait être également modélisé par une section de parabole déterminée par une relation de la forme $Th = a1 * P_{moy}^2 + b1 * P_{moy} + c1$ limitée par les points de coordonnées $(P_{moy, min} ; Th_{min})$ et $(P_{moy, max} ; Th_{max})$ dans laquelle les constantes $a1$, $b1$ et $c1$ sont établies à partir d'essais réalisés sur une gamme significative de corps creux utilisés dans les machines de dépôt de couche barrière de l'invention.

De manière plus générale, il a pu être constaté que le rapport cyclique de conduction $Th$, en pourcentage, est dépendant de la puissance moyenne de consigne $P_{moy}$ par la relation polynomiale de formule $Th = a1 * (P_{moy})^n + b1 * (P_{moy})^{n-1} + c1 * (P_{moy})^{n-2} + ... + k1 * (P_{moy})^{n-p}$, avec $n$ et $p$ des nombres entiers, $n$ étant supérieur ou égal à $p$, et $(a1, b1, c1, ... k1)$, étant des coefficients variables.

Dans le cas où l'onde est de la forme sinusoïdale, on a alors la puissance maximale $P_{max}$ qui est calculée par la relation de formule suivante $P_{max} = \pi * P_{moy} / (2 * Th)$.

De cette manière, en connaissant les deux courbes caractéristiques $P_{max} = g(P_{moy})$ et $Th = G(P_{moy})$, il suffit à l'utilisateur de définir la valeur de consigne $P_{moy}$ souhaitée pour faire fonctionner le générateur selon le premier mode de fonctionnement de l'invention.

Ainsi, de manière résumée, le premier mode de fonctionnement du générateur comprend deux alternatives dans le cas d'une utilisation d'une onde de forme sinusoïdale, soit on applique le couple de formules $(P_{max} = a * (P_{moy})^2 + b * P_{moy} + c$ ; $Th(\%) = 100 * P_{moy} * Pi / (2 * P_{max}))$, soit on applique le couple de formules $(Th = a1 * P_{moy}^2 + b1 * P_{moy} + c1$ ; $P_{max} = \pi * P_{moy} / (2 * Th))$. Le choix du couple de formules à appliquer est dépendant des paramètres de réglage du dispositif de dépôt de la couche barrière par plasma (par exemple le débit d'injection des gaz précurseurs, le volume intérieur, etc.).

À la figure 5, on a représenté un graphique établissant un second mode de fonctionnement du générateur selon l'invention (MODE 2).

On a représenté les évolutions de la puissance maximale $P_{max}$ en fonction de la puissance micro-onde moyenne $P_{moy}$. La puissance maximale $P_{max}$ du second mode de fonctionnement est déterminée en fonction des caractéristiques souhaitées des récipients après traitement. Elle est choisie dans la surface trapézoïdale limitée par les droites verticales correspondant à une puissance moyenne minimale $P_{moy, min}$ et à une puissance moyenne maximale $P_{moy, max}$, par une droite horizontale 33 correspondant à une valeur de limite supérieure de la puissance maximale $P_{max, max}$ à ne pas dépasser pour le magnétron 16 et son alimentation, et par une droite inclinée 34 comprise entre les points $(P_{moy, min} ; P_{max, min})$ et $(P_{moy, max} ; P1)$, la valeur de $P_{max, min}$ correspondant à la valeur de la puissance maximale associée à la puissance moyenne minimale $P_{moy, min}$ et la valeur de $P1$ correspondant à la valeur de la puissance maximale la plus basse possible associé à une puissance moyenne maximale $P_{moy, max}$ et passant par la droite 34, l'équation reliant ces deux points étant de la forme : $P_{max} = a2 * P_{moy} + b2$, dans laquelle les coefficients $a2$ et $b2$ sont déterminés pour que $P_{moy}$ ne dépasse jamais une valeur de rapport cyclique $Th$ limite. Cette valeur limite, constante quelque soit la puissance de consigne moyenne $P_{moy}$, est donnée par la conception du magnétron 16 et de son alimentation.

Dans un mode préféré d'opération, l'opérateur saisit sur un moyen de saisie de valeurs de puissance maximale, réalisé sur une interface homme-machine, une valeur de $P_{max}$, soit une valeur $P_{max, x}$. Le générateur comporte un moyen pour produire et indiquer sur l'interface homme-machine une plage possible PP' de puissances de consigne

$P_{moy}$ située à l'intérieur du trapèze précédemment mentionné. La plage donnée PP' sur la figure 5 est liée à deux limites de puissance maximale $P_{max}$, à savoir que la puissance maximale varie entre $P_{max, min}$ et $P_{max, max}$.

De manière résumée selon ce deuxième mode de fonctionnement, on présélectionne un $P_{max, x}$, pour ensuite choisir la valeur de $P_{moy}$ sur la droite PP'.

Pour mettre en oeuvre le second mode de fonctionnement, le dispositif de contrôle de l'invention comporte un moyen pour exécuter une séquence de calcul, la sortie dudit moyen étant connectée à un moyen pour indiquer à un opérateur la plage possible d'utilisation de $P_{moy}$ en fonction de la valeur $P_{max}$ qu'il a saisie sur un moyen de saisie d'une valeur numérique. Si lors de l'étape E4, la valeur $P_{moy}$ est en dehors de ces limites, à savoir en dehors du trapèze illustré à la figure 5, le dispositif de contrôle qui comporte un moyen pour tester la valeur de puissance moyenne $P_{moy}$ et un moyen pour interdire l'étape d'exécution d'un plasma froid, interdit le passage à l'étape E6. Le dispositif de contrôle de l'invention comporte alors un moyen pour signaler la situation d'interdiction d'exécution du plasma. Il faut, soit modifier la valeur de $P_{moy}$, soit reconsidérer la valeur de $P_{max}$ pour élargir la fenêtre de valeur $P_{moy}$ disponible lors de l'étape E4. A cette fin, le dispositif de contrôle de l'invention comporte alors un moyen pour permettre de saisir une nouvelle valeur de la puissance moyenne $P_{moy}$ en réponse à l'activation du moyen pour signaler la situation d'interdiction d'exécution du plasma et/ou un moyen pour élargir la fenêtre de valeurs de puissances maximales $P_{max}$ particulièrement par un moyen pour saisir une nouvelle valeur de la puissance maximale $P_{max}$.

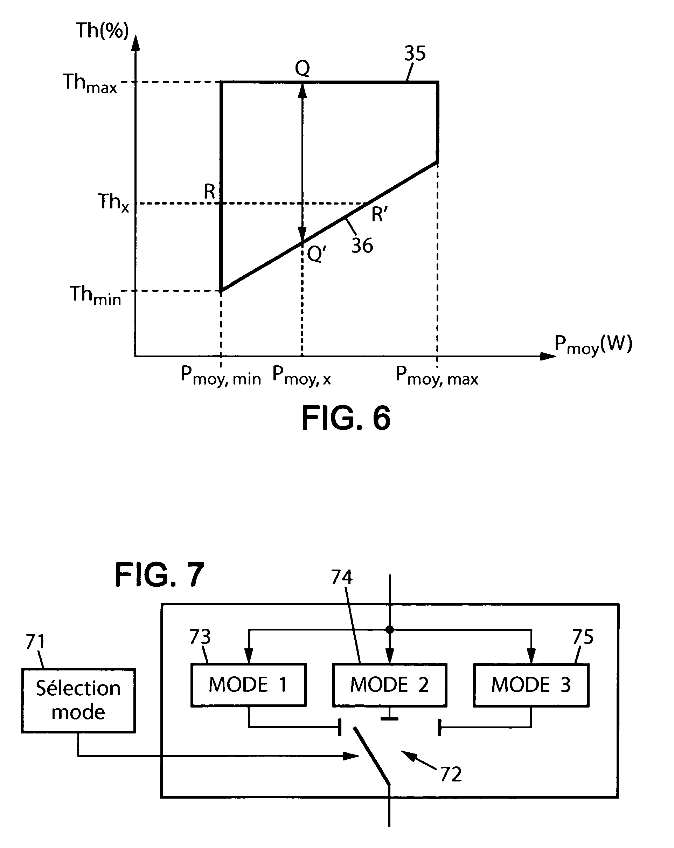

À la figure 6, on a représenté un graphique établissant un troisième mode de fonctionnement assurant les objectifs définis pour le corps creux et sa couche barrière déposée par plasma froid.

Sont représentées les surfaces de choix du rapport cyclique de conduction Th en fonction de la puissance de consigne moyenne $P_{moy}$ consommée par le magnétron 16. Le rapport cyclique Th selon le troisième mode de fonctionnement est déterminé en fonction des caractéristiques souhaitées des récipients après traitement. Il est sélectionné dans la surface trapézoïdale limitée par les droites verticales correspondant à une puissance consommée moyenne minimale $P_{moy, min}$ (associée à une valeur du rapport cyclique minimale $Th_{min}$) et une puissance consommée moyenne maximale $P_{moy, max}$, par une droite horizontale 35 correspondant à une valeur de rapport cyclique maximale $Th_{max}$ à ne pas dépasser pour la sécurité de fonctionnement du magnétron 16 et de son circuit d'alimentation utilisé dans la machine de dépôt de couche barrière de l'invention, et par une droite inclinée 36 dont l'équation est de la forme Th = c* $P_{moy}$ + d dans laquelle les coefficients c et d sont déterminés pour un type de magnétron ne devant pas dépasser une puissance maximale $P_{max}$ donnée par les caractéristiques du magnétron et de son alimentation, avec une puissance moyenne $P_{moy}$ comprise entre une valeur minimale $P_{moy, min}$ et une valeur maximale $P_{moy, max}$. Ainsi, à l'aide de ce trapèze représenté à la figure 6, il est possible de déterminer pour une puissance moyenne donnée $P_{moy, x}$, la plage QQ' dans laquelle peut varier le rapport cyclique $Th_x$.

Ainsi, selon ce troisième mode de fonctionnement, une fois que l'on a sélectionné la valeur de $Th_x$, alors la plage possible de variation de la valeur de $P_{moy}$ est représentée par la droite RR' sur la figure 6 correspondant à la droite horizontale partant du point R d'abscisse $P_{moy, min}$ et d'ordonnée $Th_x$ jusqu'au pont R' situé sur la droite 36 et d'ordonnée $Th_x$.

De manière résumée selon le troisième mode de fonctionnement, on présélectionne $Th_x$, puis on choisit $P_{moy}$ sur la droite RR'.

Pour mettre en oeuvre le troisième mode de fonctionnement, le dispositif de contrôle de l'invention comporte un moyen pour exécuter une séquence de calcul, la sortie dudit moyen étant connectée à un moyen pour indiquer à un opérateur la plage possible d'utilisation de $P_{moy}$ en fonction de la valeur Thx qu'il a saisie sur un moyen de saisie d'une valeur numérique. Si lors de l'étape E4, la valeur $P_{moy}$ est en dehors de ces limites, le dispositif de contrôle comporte et active un moyen pour interdire le passage à l'étape E6. Il faut soit modifier la valeur de $P_{moy}$, soit reconsidérer la valeur de Th pour élargir la fenêtre de valeur $P_{moy}$ disponible lors de l'étape E4. Il en résulte que le dispositif de l'invention comporte aussi un moyen pour modifier la valeur du rapport cyclique de conduction Th (ou de répétition) de la forme d'onde, un moyen pour modifier la valeur de la consigne de puissance $P_{moy}$ et un moyen pour sélectionner le premier moyen ou le second moyen précités.

À la figure 7, le dispositif de l'invention comporte aussi un circuit permettant une sélection de modes de fonctionnement représenté dans l'étape E2, circuit qui est incorporé dans le microcontrôleur et comporte un circuit 71 de sélection de mode correspondant à une demande de mode de fonctionnement. Un commutateur électronique 72 est connecté à trois circuits 72, 73 et 74 correspondant chacun à un mode de fonctionnement MODE 1 (figure 4), MODE 2 (figure 5) et MODE 3 (figure 6).

La présente invention porte donc, selon un de ses aspects, sur un dispositif de contrôle d'un générateur d'alimentation haute tension pour magnétron de dépôt de couche barrière par plasma froid de l'invention, du genre comportant :

- un circuit pour piloter un générateur d'alimentation haute tension;
- un circuit pour contrôler les électrodes de commande d'un pont d'interrupteurs de puissance haute fréquence en fonction d'une forme d'onde de puissance de consigne, ledit dispositif de contrôle mettant en oeuvre le procédé selon l'invention et comportant :

- des moyens pour mémoriser des paramètres de puissance maximale, de conduction en fonction d'un mode de fonctionnement prédéterminé,
- un moyen pour sélectionner une valeur de puissance de consigne moyenne $P_{moy}$,
- un moyen pour déterminer une fréquence de fonctionnement, de récurrence T,
- un moyen pour sélectionner un mode de fonctionnement (MODE 1, MODE 2, MODE 3) du générateur, et
- un moyen pour déterminer toutes les paramètres de consigne instantanées (puissance crête, fréquence, fréquence de

récurrence) définissant l'onde de puissance assurant un objectif de travail exprimé en termes de performance du dépôt créé sur le corps creux et le respect de son intégrité en maîtrisant son échauffement lors du dépôt.

Selon un autre de ses aspects, l'invention porte sur une machine de dépôt de couche barrière sur la paroi intérieure d'un corps creux en matériau plastique à l'aide d'un plasma froid qui est réalisée en assemblant une mécanique de transfert de corps creux, et au moins un poste de travail pour appliquer un plasma froid sur le ou les corps creux qui y sont insérés à chaque pas de fonctionnement de la mécanique de transfert de la machine.

Ce traitement nécessite l'association à chaque poste de travail d'au moins un magnétron 16 et son générateur haute tension associé.

Il est désormais vu dans la suite de la description des exemples d'application et de mise en pratique du procédé selon l'invention.

Nous avons précédemment vu que le procédé selon l'invention porte sur un procédé de contrôle d'un générateur d'alimentation électrique haute tension pour magnétron 16 destiné à produire un plasma froid à l'intérieur d'un corps creux de façon à déposer une couche barrière à l'intérieur dudit corps creux, le procédé étant caractérisé en ce qu'il consiste à choisir (étape E2) un mode de fonctionnement du générateur parmi une pluralité de modes de fonctionnement (MODE 1 , MODE 2, MODE 3), la modification du mode de fonctionnement (MODE 1, MODE 2, MODE 3) du générateur faisant varier au moins un coefficient ((a, b, c) ; (a1, b1, c1)) définissant une puissance maximale $P_{max}$ de l'onde de la puissance d'alimentation du magnétron 16 en fonction d'une puissance moyenne de consigne $P_{moy}$ du magnétron 16, l'onde d'alimentation du magnétron 16 étant répétée dans une récurrence avec un rapport cyclique de conduction Th dépendant de la puissance moyenne de consigne $P_{moy}$ et/ou de la puissance maximale Pmax .

Selon le premier mode de fonctionnement du procédé selon l'invention, la puissance maximale $P_{max}$ de l'onde est prédéterminée en fonction de la puissance de consigne $P_{moy}$.

Selon une des alternatives pour la réalisation de ce premier mode de fonctionnement, la relation entre la puissance moyenne $P_{moy}$ et la puissance maximale $P_{max}$ est de la forme parabolique $P_{max} = a*(P_{moy})^2 + b* P_{moy} + c$ avec a, b, c des coefficients variables, le rapport cyclique de conduction Th étant déterminé par la relation $Th(\%) = 100*P_{moy}*\pi/(2*P_{max})$.

De manière générale, et ce quelque soit le mode de fonctionnement du générateur, le coefficient a est compris entre (-0.002) et 0.002, le coefficient b est compris entre 0 et 4, et le coefficient c est compris entre 0 et 3000.

Plus précisément pour le premier mode de fonctionnement du générateur, a=(-0.0012), b=3.22 et c=247.6.

Ainsi, pour une puissance moyenne $P_{moy}$ de 350 W, la puissance maximale $P_{max}$ est d'environ 1230 W et le rapport cyclique calculé est d'environ 45%.

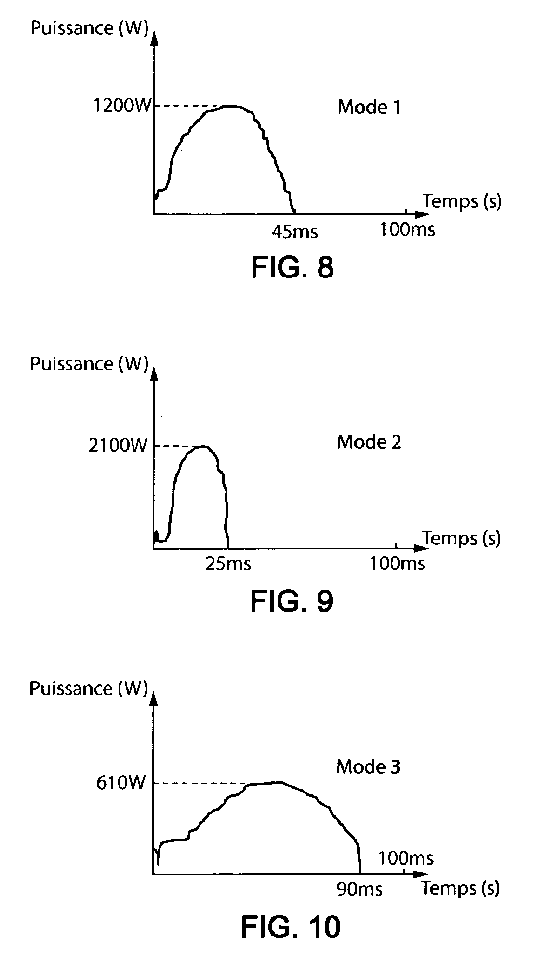

Il est ainsi illustré sur la figure 8 une représentation de la forme d'onde obtenue à partir de ces paramètres de réglage pour le premier mode de fonctionnement du générateur.

De manière alternative, il est également possible de régler un mode de fonctionnement du générateur avec le rapport cyclique de conduction Th qui est dépendant de la puissance moyenne de consigne $P_{moy}$ par la relation de formule $Th(\%) = a1(P_{moy})^2 + b1*P_{moy} + c1$ avec a1, b1, c1 étant des coefficients variables, la puissance maximale $P_{max}$ étant alors déterminée par la relation $P_{max} = \pi*P_{moy}/(2*Th)$. Les coefficients a1, b1 et c1 définissent ainsi également une relation entre la puissance maximale $P_{max}$ et la puissance moyenne $P_{moy}$.

A titre d'exemple, les valeurs de a1 peuvent être comprises entre $(-10^{-7})$ et $(-10^{-4})$, les valeurs des b1 peuvent être comprises entre 0.03 et 0.06, et les valeurs de c1 peuvent être comprises entre 25 et 30. De manière préférentielle, a1 vaut $(-5*10^{-6})$, b1 vaut 0.0529 et c1 vaut 27.85.

De manière préférentielle, dans un mode de fonctionnement, par exemple le MODE 1, aucun des coefficients ((a, b, c) ;(a1, b1, c1)) n'est nul.

Dans un autre mode de fonctionnement (MODE 2, MODE 3) du générateur, au moins deux coefficients a, b et c sont nuls.

Plus précisément, dans un deuxième mode de fonctionnement (MODE 2), la puissance maximale $P_{max}$ est fixée constante, préférentiellement à la valeur de 2100W avec une valeur limite supérieure du rapport cyclique $Th_{max}$ de 90%.

Selon ce deuxième mode de fonctionnement, les valeurs des coefficients a et b sont nulles et la valeur de c vaut donc 2100.

On a alors un rapport cyclique Th linéairement dépendant de la puissance moyenne $P_{moy}$, préférentiellement, dans le cas où l'onde est du type sinusoïdal, Th vaut environ 0.07 $P_{moy}$. La valeur de Th est calculée par la relation Th (%) = 100$_*$$P_{moy}$*$\pi$/(2*$P_{max}$), dans le cas où l'onde est du type sinusoïdal.

Ainsi, pour une puissance moyenne $P_{moy}$ de 350W, la puissance maximale $P_{max}$ est de 2100W et le rapport cyclique Th est de 25% et il est obtenu la forme d'onde telle que représentée sur la figure 9.

Il a été précédemment décrit et illustré à la figure 5, que, selon ce deuxième mode de réalisation, la puissance maximale $P_{max}$ est déterminée et apte à varier sur la base d'une surface de sécurité limitée par une valeur maximale admissible de la puissance maximale $P_{max,\ max}$ pour le magnétron 16 et une valeur inférieure de la puissance maximale $P_{max,\ min}$ déterminée par un rapport cyclique de conduction maximum $Th_{max}$ donné par la conception du magnétron 16 et de son alimentation.

Selon un troisième mode de fonctionnement du générateur, la puissance maximale $P_{max}$ est linéairement dépendante de la valeur de la puissance de consigne moyenne $P_{moy}$.

Dans ce cas, les coefficients a et c sont nuls et, de manière préférentielle, la valeur de b est fixée à 1.745, donc $P_{max}$=1.745$P_{moy}$.

Selon ce troisième mode de réalisation, le rapport cyclique de conduction Th est fixe, et préférentiellement fixé à 90%.

Ainsi, pour une puissance moyenne $P_{moy}$ de 350 W, la puissance maximale $P_{max}$ est de 610 W et il est obtenu la forme d'onde telle que représentée sur la figure 10.

Il a été précédemment décrit et illustré à la figure 6, que, selon ce troisième mode de réalisation, le rapport cyclique de conduction Th de la forme d'onde est déterminé et apte à varier sur la base d'une surface de sécurité limitée par une valeur du rapport cyclique de conduction maximale admissible $Th_{max}$ et une valeur inférieure du rapport cyclique de conduction minimale $Th_{min}$ déterminée en fonction de la limitation supérieure de la puissance maximale admise $P_{max,\ max}$ qui dépend des caractéristiques du magnétron 16 et de son alimentation.

De manière générale, les coefficients ((a, b, c) ; (a1, b1, c1)) sont déterminés par des essais de traitement d'un lot de corps creux dont on tire la relation optimale entre la puissance moyenne de consigne $P_{moy}$, la puissance maximale $P_{max}$ et le rapport cyclique de conduction Th.

Afin de tester l'étanchéité de la couche barrière interne formée à partir des différents modes de contrôle du générateur, il a été procédé à des tests comparatifs des trois modes par l'injection d'un gaz d'acétylène $C_2H_2$ dans le volume intérieur d'un corps creux, tel qu'une bouteille, placé dans une cavité. En effet, le dispositif de dépôt de couche barrière par formation d'un plasma est composé d'une cavité métallique de forme cylindrique, dans laquelle est apte à être placée le corps creux, et d'un guide d'onde microonde dans lequel se trouve une antenne microondes connectée au générateur de puissance, cette cavité étant elle-même reliée à un système de vide et un système d'injection des gaz, tel que de l'acétylène. Les paramètres de réglage sont une puissance moyenne $P_{moy}$ comprise entre 200 W et 450 W, un débit de gaz d'acétylène, injecté dans le volume intérieur du corps creux, compris entre 60 sccm et 160 sccm (standard cubic centimeters per minute) et un temps de dépôt compris entre 1.2 et 4 secondes. Les autres paramètres comme la pression de dépôt et la fréquence des pulses sont restés constants.

Il a été testé, dans chacun des exemples suivants, un lot de cinq bouteilles pour chacun des trois modes de fonctionnement, les valeurs de perméabilité à l'oxygène obtenues étant mesurée à l'aide d'un système de mesure Ox-Tran (marque déposée) fournissant des valeurs en cc/bouteille/24h.

Les bouteilles utilisées sont des bouteilles en PET d'un volume de 520 mL et d'un poids de 28 g, sachant que la valeur de la perméabilité d'une bouteille en PET sans revêtement est de 0.04 cc/bouteille/24h.

● Exemple n°1

Les paramètres de réglage sont les suivants :
- Débit d'acétylène 160 sccm
- Puissance moyenne de consigne 350 W
- Temps de dépôt 1.4 s
- Fréquence de pulse 100 Hz

| Mode de fonctionnement du générateur | Mode 1 | Mode 2 | Mode 3 |
|---|---|---|---|
| Valeur moyenne de la perméabilité | 0.0029 | 0.0021 | 0.0110 |
| BIF (Barrier improvement factor), rapport des valeurs de la perméabilité d'une bouteille non traitée à une bouteille traitée | 13.7 | 19 | 3.6 |

Il peut être remarqué que selon ces paramètres de réglage, les facteurs d'amélioration de la perméabilité (ou BIF) sont les meilleurs pour les modes 1 et 2.

● Exemple n°2

Les paramètres de réglage sont les suivants :
- Débit d'acétylène 60 sccm
- Puissance moyenne de consigne 200 W
- Temps de dépôt 4 s
- Fréquence de pulse 100 Hz

| Mode de fonctionnement du générateur | Mode 1 | Mode 2 | Mode 3 |
|---|---|---|---|
| Valeur moyenne de la perméabilité | 0.0.0043 | 0.0037 | 0.0171 |
| BIF (Barrier improvement factor), rapport des valeurs de la perméabilité d'une bouteille non traitée à une bouteille traitée | 9.3 | 10.8 | 2.3 |

Il peut être également remarqué que selon ces paramètres de réglage, les facteurs d'amélioration de la perméabilité (ou BIF) sont les meilleurs pour les modes 1 et 2.

● Exemple n°3

Les paramètres de réglage sont les suivants :

- Débit d'acétylène 120 sccm
- Puissance moyenne de consigne 210 W
- Temps de dépôt 1.4 s
- Fréquence de pulse 100 Hz

| Mode de fonctionnement du générateur | Mode 1 | Mode 2 | Mode 3 |
|---|---|---|---|
| Valeur moyenne de la perméabilité | 0.0141 | 0.0044 | 0.0231 |
| BIF (Barrier improvement factor), rapport des valeurs de la perméabilité d'une bouteille non traitée à une bouteille traitée | 2.8 | 9.1 | 1.7 |

Il peut être remarqué que, selon ces paramètres de réglage, le facteur d'amélioration de la perméabilité (ou BIF) est le meilleur pour le mode 2.

De manière similaire, il a été testé l'efficacité des trois modes de fonctionnement du générateur selon l'invention pour le dépôt d'une couche barrière interne par dépôt successif de deux couches différentes, avec un premier dépôt issu de l'injection, dans le volume intérieur du corps creux, d'un mélange de gaz HMDSO (hexaméthyldisiloxane) et azote $N_2$, et un deuxième dépôt issu de l'injection, dans le volume intérieur du corps creux, d'un mélange gazeux de HMDSO, d'azote gazeux $N_2$ et de dioxygène $O_2$.

Les paramètres variables testés portent sur la puissance moyenne $P_{moy}$ variant de 200 W à 450 W, le débit du gaz HMDSO variant de 4 à 20 sccm, le débit d'azote variant de 10 à 100 sccm, le débit d'oxygène variant de 40 à 200 sccm, le temps de dépôt pour la première couche variant de 0.5 à 2 secondes, et le temps de dépôt pour la deuxième couche variant de 2 à 4 secondes.

Les bouteilles présentent les mêmes caractéristiques que précédemment, à savoir un volume de 520 mL et un poids de 28 g. Les valeurs de perméabilité à l'oxygène obtenues sont mesurées à l'aide d'un système de mesure Ox-Tran (marque déposée) fournissant des valeurs en cc/bouteille/24h, sachant que la valeur de la perméabilité d'une bouteille en PET sans revêtement est de 0.04 cc/bouteille/24h.

Nous allons voir ci-dessous trois exemples de tests comparatifs pour les trois modes de fonctionnement d'un tel dépôt barrière bi-couches avec une étape 1 pour le dépôt de la première couche et une étape 2 pour le dépôt de la deuxième couche.

● Exemple 4

Conditions opératoires

|  | Etape 1 | Etape 2 |
|---|---|---|
| Débit HMDSO (sccm) | 6 | 6 |
| Débit d'oxygène (sccm) | 0 | 60 |
| Débit d'azote (sccm) | 62 | 62 |
| Puissance moyenne $P_{moy}$ (W) | 350 | 350 |
| Temps de dépôt (s) | 0.5 | 2.5 |

Les résultats obtenus sont résumés dans le tableau ci-dessous

| Mode de fonctionnement du générateur | Mode 1 | Mode 2 | Mode 3 |
|---|---|---|---|
| Valeur moyenne de la perméabilité | 0.0080 | 0.0112 | 0.0078 |
| BIF (Barrier improvement factor), rapport des valeurs de la perméabilité d'une bouteille non traitée à une bouteille traitée | 5 | 3.6 | 5.1 |

● Exemple 5

Conditions opératoires (avec une puissance moyenne $P_{moy}$ inférieure à la puissance moyenne $P_{moy}$ par rapport aux conditions opératoires de l'exemple 4)

|  | Etape 1 | Etape 2 |
|---|---|---|
| Débit HMDSO (sccm) | 6 | 6 |
| Débit d'oxygène (sccm) | 0 | 60 |
| Débit d'azote (sccm) | 62 | 62 |
| Puissance moyenne de consigne $P_{moy}$ (W) | 250 | 250 |
| Temps de dépôt (s) | 0.5 | 2.5 |

Les résultats obtenus sont résumés dans le tableau ci-dessous

| Mode de fonctionnement du générateur | Mode 1 | Mode 2 | Mode 3 |
|---|---|---|---|
| Valeur moyenne de la perméabilité | 0.0080 | 0.0099 | 0.0091 |
| BIF (Barrier improvement factor), rapport des valeurs de la perméabilité d'une bouteille non traitée à une bouteille traitée | 5 | 4 | 4.4 |

● Exemple 6

Conditions opératoires (avec une diminution de la puissance moyenne $P_{moy}$ uniquement pour l'étape 1 par rapport aux conditions opératoires de l'exemple 4)

|  | Etape 1 | Etape 2 |
|---|---|---|
| Débit HMDSO (sccm) | 6 | 6 |
| Débit d'oxygène (sccm) | 0 | 60 |

(suite)

|  | Etape 1 | Etape 2 |
|---|---|---|
| Débit d'azote (sccm) | 62 | 62 |
| Puissance moyenne de consigne $P_{moy}$ (W) | 250 | 350 |
| Temps de dépôt (s) | 0.5 | 2.5 |

Les résultats obtenus sont résumés dans le tableau ci-dessous

| Mode de fonctionnement du générateur | Mode 1 | Mode 2 | Mode 3 |
|---|---|---|---|
| Valeur moyenne de la perméabilité | 0.0069 | 0.0069 | 0.0081 |
| BIF (Barrier improvement factor), rapport des valeurs de la perméabilité d'une bouteille non traitée à une bouteille traitée | 5.8 | 5.8 | 4.9 |

Il peut ainsi être remarqué que dans les exemples 4 à 6, les trois modes de fonctionnement sont à peu près équivalents, même si le mode 2 est le moins bon en terme de BIF dans l'exemple 4 et le mode 3 dans l'exemple 6.

Il est ainsi possible selon le procédé de l'invention de sélectionner avec rapidité et simplicité les paramètres caractéristiques d'une onde optimale pour la formation d'une couche barrière interne dans un corps creux et faisant varier des coefficients variables liant la puissance maximale $P_{max}$, la puissance moyenne $P_{moy}$ et le rapport cyclique de récurrence Th.

## Revendications

1. Procédé de contrôle d'un générateur d'alimentation électrique haute tension pour magnétron (16) destiné à produire un plasma froid à l'intérieur d'un corps creux de façon à déposer une couche barrière à l'intérieur dudit corps creux, **caractérisé en ce qu'**il consiste à choisir (E2) un mode de fonctionnement du générateur parmi une pluralité de modes de fonctionnement (MODE 1 , MODE 2, MODE 3), la modification du mode de fonctionnement (MODE 1, MODE 2, MODE 3) du générateur faisant varier au moins un coefficient ((a, b, c) ; (a1, b1, c1)) définissant une puissance maximale $P_{max}$ de la forme d'onde de la puissance d'alimentation du magnétron (16) en fonction d'une puissance moyenne de consigne $P_{moy}$ du magnétron (16), la forme d'onde d'alimentation du magnétron (16) étant répétée dans une récurrence avec un rapport cyclique de conduction Th dépendant de la puissance moyenne de consigne $P_{moy}$ et/ou de la puissance maximale $P_{max}$ .

2. Procédé selon la revendication 1, **caractérisé en ce que** la puissance maximale $P_{max}$ de la forme d'onde est prédéterminée en fonction de la puissance de consigne $P_{moy}$.

3. Procédé selon la revendication 1 ou 2, **caractérisé en ce que** ladite relation entre la puissance moyenne $P_{moy}$ et la puissance maximale $P_{max}$ est de la forme polynomiale $P_{max}= a*(P_{moy})^n + b*(P_{moy})^{n-1} + C*(P_{moy})^{n-2} +... + k*(P_{moy})^{n-p}$, avec n et p des nombres entiers, n étant supérieur ou égal à p, et (a, b, c,...k), étant des coefficients variables.

4. Procédé selon la revendication 3, **caractérisé en ce que** ladite relation polynomiale est de forme parabolique $P_{max} =a*(P_{moy})^2+b*P_{moy} +c$ avec a, b, c étant des coefficients variables.

5. Procédé selon la revendication 3 ou 4, **caractérisé en ce que** le rapport cyclique de conduction Th, en pourcentage, est déterminé par la relation $Th=100*P_{moy}*\pi/(2*P_{max})$.

6. Procédé selon la revendication 1, **caractérisé en ce que** le rapport cyclique de conduction Th, en pourcentage, est dépendant de la puissance moyenne de consigne $P_{moy}$ par la relation polynomiale de formule $Th=a1*(P_{moy})^n+b1*(P_{moy})^{n-1}+c1*(P_{moy})^{n-2}+...+k1*(P_{moy})^{n-p}$, avec n et p des nombres entiers, n étant supérieur ou égal à p, et (a1, b1, c1,...k1), étant des coefficients variables.

7. Procédé selon la revendication précédente, **caractérisé en ce que** ladite relation polynomiale est de forme parabolique $Th=a1(P_{moy})^2+b1*P_{moy}+c1$ avec a1, b1, c1 étant des coefficients variables.

**8.** Procédé selon la revendication 6 ou 7, **caractérisé en ce que** la puissance maximale $P_{max}$ est déterminée par la relation $P_{max}=\pi*P_{moy}/(2*Th)$.

**9.** Procédé selon l'une quelconque des revendications 3 à 8, **caractérisé en ce que**, dans un mode de fonctionnement (MODE 1), aucun des coefficients $((a, b, c) ;(a1, b1, c1))$ n'est nul.

**10.** Procédé selon l'une quelconque des revendications 3 à 8, **caractérisé en ce que**, dans un mode de fonctionnement (MODE 2, MODE 3), au moins deux coefficients $((a, b, c) ;(a1, b1, c1))$ sont nuls.

**11.** Procédé selon l'une quelconque des revendications 1 à 8 et 10, **caractérisé en ce que**, dans un mode de fonctionnement (MODE 2), la puissance maximale $P_{max}$ est fixée constante

**12.** Procédé selon la revendication précédente, **caractérisé en ce que** le rapport cyclique Th est linéairement dépendant de la puissance moyenne $P_{moy}$.

**13.** Procédé selon l'une quelconque des revendications 10 à 12, **caractérisé en ce que** la puissance maximale est déterminée et apte à varier sur la base d'une surface de sécurité limitée par une valeur maximale admissible de la puissance maximale $P_{max, \, max}$ pour le magnétron (16) et une valeur inférieure de la puissance maximale $P_{max, \, min}$ déterminée par un rapport cyclique de conduction maximum $Th_{max}$ donné par la conception du magnétron (16) et de son alimentation.

**14.** Procédé selon l'une quelconque des revendications 1 à 8 et 10, **caractérisé en ce que**, dans un mode de fonctionnement (MODE 3), la puissance maximale $P_{max}$ est linéairement dépendante de la valeur de la puissance de consigne moyenne $P_{moy}$.

**15.** Procédé selon la revendication précédente, **caractérisé en ce que** le rapport cyclique de conduction Th est fixe.

**16.** Procédé selon l'une quelconque des revendications 10, 14 ou 15, **caractérisé en ce que** le rapport cyclique de conduction Th de la forme d'onde est déterminé et apte à être choisi sur la base d'une surface de sécurité limitée par une valeur du rapport cyclique de conduction maximale admissible $Th_{max}$ et une valeur inférieure du rapport cyclique de conduction minimale $Th_{min}$ déterminée en fonction de la limitation supérieure de la puissance maximale admise $P_{max, \, max}$ qui dépend des caractéristiques du magnétron (16) et de son alimentation.

**17.** Procédé selon l'une quelconque des revendications 3 à 16, **caractérisé en ce que** lesdits coefficients $((a, b, c) ; (a1, b1, c1))$ sont déterminés par des essais de traitement d'un lot de corps creux dont on tire une relation entre la puissance moyenne de consigne $P_{moy}$, la puissance maximale $P_{max}$ et le rapport cyclique de conduction Th.

**18.** Procédé selon l'une quelconque des revendications 3 à 16, **caractérisé en ce que** le coefficient a est compris entre (-0.0020) et 0.0020, **en ce que** le coefficient b est compris entre 0 et 4, et **en ce que** le coefficient c est compris entre 0 et 3000.

**19.** Dispositif de contrôle d'un générateur d'alimentation haute tension pour magnétron de dépôt de couche barrière par plasma froid de l'invention, du genre comportant :

    - un circuit pour piloter un générateur d'alimentation haute tension;
    - un circuit pour contrôler les électrodes de commande d'un pont d'interrupteurs de puissance en fonction d'une forme d'onde de puissance de consigne, ledit dispositif de contrôle mettant en oeuvre le procédé selon l'une quelconque des revendications précédentes et comportant :
    - des moyens pour mémoriser des paramètres de puissance maximale, de conduction en fonction d'un mode de fonctionnement prédéterminé,
    - un moyen pour sélectionner une valeur de consigne de puissance moyenne $P_{moy}$,
    - un moyen pour déterminer une fréquence de fonctionnement,
    - un moyen pour sélectionner un mode de fonctionnement du générateur (MODE 1, MODE 2, MODE 3), et
    - un moyen pour déterminer toutes les caractéristiques de consigne instantanées définissant l'onde de puissance assurant un objectif de travail exprimé en termes de performance du dépôt créé sur le corps creux et le respect de son intégrité en maîtrisant son échauffement lors du dépôt.

**20.** Machine de dépôt de couche barrière sur la paroi intérieure d'un corps creux en matériau plastique, du type bouteille, à l'aide d'un plasma froid excité par un magnétron (16), alimenté par un générateur haute tension, contrôlé par un dispositif de contrôle selon la revendication précédente.

**Claims**

1. A method for controlling a high-voltage power supply generator for a magnetron (16) for producing a cold plasma inside a hollow body in order to carry out the deposition of a barrier layer within said hollow body, **characterized in that** it consists in selecting (E2) a generator operating mode from a plurality of operating modes (MODE 1, MODE 2, MODE 3), a modification of the operating mode (MODE 1, MODE 2, MODE 3) of the generator varying at least one coefficient ((a, b, c,); (a1, b1, c1)) defining a maximum power $P_{max}$ of the waveform of the supply power of the magnetron (16) in relation with an average power setpoint $P_{avg}$ of the magnetron (16), the magnetron (16) supply waveform being repeated recurrently with a cyclic conduction ratio Th depending on the average power setpoint $P_{avg}$ and/or the maximum power $P_{max}$.

2. The method as claimed in claim 1, **characterized in that** the maximum power $P_{max}$ of the waveform is predetermined in relation with the power setpoint $P_{avg}$.

3. The method as claimed in claim 1 or 2, **characterized in that** said relation between the average power $P_{avg}$ and the maximum power $P_{max}$ has the polynomial form

$$P_{max} = a*(P_{avg})^{n} + b*(P_{avg})^{n-1} + c*(P_{avg})^{n-2} +... + k*(P_{avg})^{n-p}$$

where n and p are whole numbers, n being higher than or equal to p, and (a, b, c,... k) being variable coefficients.

4. The method as claimed in claim 3, **characterized in that** said polynomial equation has the parabolic form $P_{max} = a*(P_{avg})^2 + b*P_{avg} + c$ where a, b, c are variable coefficients.

5. The method as claimed in claim 3 or 4, **characterized in that** the cyclic conduction ratio Th, in percent, is determined by the equation

$$Th = 100*P_{avg}*\pi/(2*P_{max}).$$

6. The method as claimed in claim 1, **characterized in that** the cyclic conduction ratio Th, in percent, is dependent on the average power setpoint $P_{avg}$ via the polynomial equation having the formula

$$Th = a1*(P_{avg})^{n} + b1*(P_{avg})^{n-1} + c1*(P_{avg})^{n-2} +... + k1*(P_{avg})^{n-p}$$

where n and p are whole numbers, n being higher than or equal to p, and (a1, b1, c1,... k1) being variable coefficients.

7. The method as claimed in the preceding claim, **characterized in that** said polynomial equation has the parabolic form $Th = a1 (P_{avg})^2 + b1*P_{avg} + c1$, where a1, b1, c1 are variable coefficients.

8. The method as claimed in claim 6 or 7, **characterized in that** the maximum power $P_{max}$ is determined by the equation $P_{max} = \pi*P_{avg}/(2*Th)$.

9. The method as claimed in any one of claims 3 to 8, **characterized in that**, in an operating mode (MODE 1), none of the coefficients ((a, b, c); (a1, b1, c1)) is zero.

10. The method as claimed in any one of claims 3 to 8, **characterized in that**, in an operating mode (MODE 2, MODE 3), at least two coefficients ((a, b, c); (a1, b1, c1)) are zero.

11. The method as claimed in any one of claims 1 to 8 and 10, **characterized in that**, in an operating mode (MODE 2), the maximum power $P_{max}$ is fixed constant.

**12.** The method as claimed in the preceding claim, **characterized in that** the cyclic ratio Th is linearly dependent on the average power $P_{avg}$.

**13.** The method as claimed in any one of claims 10 to 12, **characterized in that** the maximum power is determined and variable on the basis of a safe area bounded by a maximum permissible value of the maximum power $P_{max, max}$ for the magnetron (16) and a lower value of the maximum power $P_{max, min}$ determined by a maximum cyclic conduction ratio $Th_{max}$ given by the design of the magnetron (16) and of the power supply thereof.

**14.** The method as claimed in any one of claims 1 to 8 and 10, **characterized in that**, in an operating mode (MODE 3), the maximum power $P_{max}$ is linearly dependent on the value of the average power setpoint $P_{avg}$.

**15.** The method as claimed in the preceding claim, **characterized in that** the cyclic conduction ratio Th is fixed.

**16.** The method as claimed in any one of claims 10, 14 or 15, **characterized in that** the cyclic conduction ratio Th of the waveform is determined and selectable on the basis of a safe area bounded by a value of the maximum permissible cyclic conduction ratio $Th_{max}$ and a lower value of the minimum cyclic conduction ratio $Th_{min}$ determined according to the upper limit of the maximum permissible power $P_{max, max}$ which depends on the characteristics of the magnetron (16) and of the power supply thereof.

**17.** The method as claimed in any one of claims 3 to 16, **characterized in that** said coefficients ((a, b, c); (a1, b1, c1)) are determined by treatment tests of a batch of hollow bodies from which a relation is derived between the average power setpoint $P_{avg}$, the maximum power $P_{max}$ and the cyclic conduction ratio Th.

**18.** The method as claimed in any one of claims 3 to 16, **characterized in that** the coefficient a is between (-0.0020) and 0.0020, **in that** the coefficient b is between 0 and 4, and **in that** the coefficient c is between 0 and 3000.

**19.** A device for controlling a high-voltage power supply generator for magnetron for the cold-plasma deposition of a barrier layer of the invention, of the type comprising:

- a circuit for controlling a high-voltage power supply generator;
- a circuit for controlling the control electrodes of a power switch bridge in relation with a power waveform setpoint, said control device using the method as claimed in any one of the preceding claims and comprising:
- means for storing parameters of maximum power, of conduction in relation with a predefined operating mode,
- means for selecting an average power setpoint $P_{avg}$,
- means for determining an operating frequency,
- means for selecting a generator operating mode (MODE 1, MODE 2, MODE 3), and
- means for determining all the instantaneous setpoint characteristics defining the power wave for a work target expressed in terms of performance of the deposit created on the hollow body and the respect of the integrity thereof, while controlling its temperature rise during the deposition.

**20.** A machine for depositing a barrier layer on the inside wall of a plastic hollow body, such as a bottle, using a cold plasma excited by a magnetron (16), supplied by a high-voltage generator, controlled by a control device as claimed in the preceding claim.

**Patentansprüche**

**1.** Verfahren zum Steuern eines Hochspannungsstromversorgungsgenerators für ein Magnetron (16), das dazu bestimmt ist, ein kaltes Plasma im Inneren eines Hohlkörpers zu erzeugen, derart, dass im Inneren des Hohlkörpers eine Sperrschicht abgeschieden wird, **dadurch gekennzeichnet, dass** es darin besteht, eine Betriebsweise des Generators unter mehreren Betriebsweisen (MODE 1, MODE 2, MODE 3) auszuwählen (E2), wobei durch die Änderung der Betriebsweise (MODE1, MODE2, MODE 3) des Generators mindestens ein Koeffizient ((a, b, c); (a1, b1, c1)) variiert wird, der eine Höchstleistung $P_{max}$ der Wellenform der Versorgungsleistung des Magnetrons (16) in Abhängigkeit von einer mittleren Sollleistung $P_{moy}$ des Magnetrons (16) definiert, wobei die Versorgungswellenform des Magnetrons (16) in einer Rekurrenz mit einem zyklischen Leitungsverhältnis Th wiederholt wird, das von der mittleren Sollleistung $P_{moy}$ und/oder der Höchstleistung $P_{max}$ abhängt.

**2.** Verfahren nach Anspruch 1, **dadurch gekennzeichnet, dass** die Höchstleistung $P_{max}$ der Wellenform in Abhän-

gigkeit von der Sollleistung $P_{moy}$ vorbestimmt wird.

3. Verfahren nach Anspruch 1 oder 2, **dadurch gekennzeichnet, dass** das Verhältnis zwischen der mittleren Leistung $P_{moy}$ und der Höchstleistung $P_{max}$ die Polynomform $P_{max} = a * (P_{moy})^n + b * (P_{moy})^{n-1} + c * (P_{moy})^{n-2} + ... + k * (P_{moy})^{n-p}$ aufweist, wobei n und p Ganzzahlen sind, n größer oder gleich p ist und (a, b, c, ... k) variable Koeffizienten sind.

4. Verfahren nach Anspruch 3, **dadurch gekennzeichnet, dass** die Polynombeziehung die parabolische Form $P_{max} = a * (P_{moy})^2 + b * P_{moy} + c$ aufweist, wobei a, b und c variable Koeffizienten sind.

5. Verfahren nach Anspruch 3 oder 4, **dadurch gekennzeichnet, dass** das zyklische Leitungsverhältnis Th als Prozentsatz durch die Beziehung $Th = 100 * P_{moy} * \pi / (2 * P_{max})$ bestimmt ist.

6. Verfahren nach Anspruch 1, **dadurch gekennzeichnet, dass** das zyklische Leitungsverhältnis Th als Prozentsatz von der mittleren Sollleistung $P_{moy}$ durch die Polynombeziehung mit der Formel $Th = a1 * (P_{moy})^n + b1 * (P_{moy})^{n-1} + C1 * (P_{moy})^{n-2} + ... + k1 * (P_{moy})^{n-p}$ abhängig ist, wobei n und p Ganzzahlen sind, n größer oder gleich p ist und (a1, b1, c1, ...k1) variable Koeffizienten sind.

7. Verfahren nach dem vorhergehenden Anspruch, **dadurch gekennzeichnet, dass** die Polynombeziehung die parabolische Form $Th = a1 (P_{moy})^2 + b1 * P_{moy} + c1$ aufweist, wobei a1, b1 und c1 variable Koeffizienten sind.

8. Verfahren nach Anspruch 6 oder 7, **dadurch gekennzeichnet, dass** die Höchstleistung $P_{max}$ durch die Beziehung $P_{max} = \pi * P_{moy} / (2 * Th)$ bestimmt ist.

9. Verfahren nach einem der Ansprüche 3 bis 8, **dadurch gekennzeichnet, dass** in einer Betriebsweise (MODE 1) keiner der Koeffizienten ((a, b, c,); (a1, b1, c1)) Null ist.

10. Verfahren nach einem der Ansprüche 3 bis 8, **dadurch gekennzeichnet, dass** in einer Betriebsweise (MODE 2, MODE 3) mindestens zwei Koeffizienten ((a, b, c,); (a1, b1, c1)) Null sind.

11. Verfahren nach einem der Ansprüche 1 bis 8 und 10, **dadurch gekennzeichnet, dass** in einer Betriebsweise (MODE 2) die Höchstleistung $P_{max}$ konstant festgelegt ist.

12. Verfahren nach dem vorhergehenden Anspruch, **dadurch gekennzeichnet, dass** das zyklische Verhältnis Th linear von der mittleren Leistung $P_{moy}$ abhängig ist.

13. Verfahren nach einem der Ansprüche 10 bis 12, **dadurch gekennzeichnet, dass** die Höchstleistung bestimmt ist und geeignet ist, auf der Grundlage einer Sicherheitsfläche zu variieren, die durch einen zulässigen Höchstwert der Höchstleistung $P_{max, max}$ für das Magnetron (16) und einen unteren Wert der Höchstleistung $P_{max, min}$ begrenzt ist, der durch ein durch die Gestaltung des Magnetrons (16) und seiner Versorgung gegebenes maximales zyklisches Leitungsverhältnis $Th_{max}$ bestimmt wird.

14. Verfahren nach einem der Ansprüche 1 bis 8 und 10, **dadurch gekennzeichnet, dass** die Höchstleistung $P_{max}$ in einer Betriebsweise (MODE 3) linear vom mittleren Sollleistungswert $P_{moy}$ abhängig ist.

15. Verfahren nach dem vorhergehenden Anspruch, **dadurch gekennzeichnet, dass** das zyklische Leitungsverhältnis Th fest ist.

16. Verfahren nach einem der Ansprüche 10, 14 oder 15, **dadurch gekennzeichnet, dass** das zyklische Leitungsverhältnis Th der Wellenform bestimmt ist und geeignet ist, um auf der Grundlage einer Sicherheitsfläche gewählt zu werden, die durch einen Wert des zulässigen maximalen zyklischen Leitungsverhältnisses $Th_{max}$ und einen unteren Wert des zyklischen Mindestleitungsverhältnisses $Th_{min}$ begrenzt ist, der in Abhängigkeit von der oberen Begrenzung der zulässigen Höchstleistung $P_{max, max}$ bestimmt wird, die von den Eigenschaften des Magnetrons (16) und seiner Versorgung abhängig ist.

17. Verfahren nach einem der Ansprüche 3 bis 16, **dadurch gekennzeichnet, dass** die Koeffizienten ((a, b, c) ; (a1, b1, c1)) durch Versuche der Verarbeitung eines Satzes von Hohlkörpern bestimmt werden, von denen ein Verhältnis zwischen der mittleren Sollleistung $P_{moy}$, der Höchstleistung $P_{max}$ und dem zyklischen Leitungsverhältnis Th abgeleitet wird.

**18.** Verfahren nach einem der Ansprüche 3 bis 16, **dadurch gekennzeichnet, dass** der Koeffizient a zwischen (-0.0020) und 0.0020 enthalten ist, und dadurch, dass der Koeffizient b zwischen 0 und 4 enthalten ist, und dadurch, dass der Koeffizient c zwischen 0 und 3000 enthalten ist.

**19.** Vorrichtung zur erfindungsgemäßen Steuerung eines Hochspannungsversorgungsgenerators für ein Magnetron zum Abscheiden einer Sperrschicht durch kaltes Plasma, der Art, die Folgendes umfasst:

- eine Schaltung zur Steuerung eines Hochspannungsversorgungsgenerators;
- eine Schaltung zur Steuerung der Steuerelektroden einer Leistungsschalterbrücke in Abhängigkeit von einer Sollleistungswellenform, wobei die Steuervorrichtung das Verfahren nach einem der vorhergehenden Ansprüche einsetzt und Folgendes umfasst:
- Mittel zum Speichern der Parameter der Höchstleitungsleistung in Abhängigkeit von einer vorbestimmten Betriebsweise,
- ein Mittel zum Auswählen eines Sollwerts für die mittlere Leistung $P_{moy}$,
- ein Mittel zum Bestimmen einer Betriebsfrequenz,
- ein Mittel zum Auswählen einer Betriebsweise des Generators (MODE 1, MODE 2, MODE 3), und
- ein Mittel zum Bestimmen sämtlicher Momentansollmerkmale, die die Leistungswelle definieren, die ein Arbeitsziel, das hinsichtlich der Leistung des auf dem Hohlkörper erzeugten Abscheidens ausgedrückt ist, und die Wahrung seiner Unversehrtheit durch Beherrschen seiner Erhitzung beim Abscheiden gewährleisten.

**20.** Maschine zum Abscheiden einer Sperrschicht auf der Innenwand eines Hohlkörpers aus Kunststoff des Typs Flasche mittels eines kalten Plasmas, das durch ein Magnetron (16) erregt wird, das durch einen Hochspannungsgenerator versorgt wird, der durch eine Steuervorrichtung nach dem vorhergehenden Anspruch gesteuert wird.

## FIG. 1

**FIG. 2**

**FIG. 3**

Paramétrage
initial

Sélection forme d'onde — E1

Sélection mode — E2

Paramétrage du mode — E3

Paramétrage
process

Sélection de la puissance
de consigne moyenne $P_{moy}$ — E4

Génération de la
forme d'onde

Calcul des paramètres restants et génération
de la forme d'onde — E5

Régulation
micro-ondes

Exécuter plasma — E6

FIG. 4a

FIG. 4b

FIG. 5

**FIG. 6**

**FIG. 7**

Puissance (W)

1200W

Mode 1

Temps (s)

45ms  100ms

## FIG. 8

Puissance (W)

2100W

Mode 2

Temps (s)

25ms  100ms

## FIG. 9

Puissance (W)

610W

Mode 3

100ms

90ms  Temps (s)

## FIG. 10

**EP 2 050 121 B1**

## RÉFÉRENCES CITÉES DANS LA DESCRIPTION

### Documents brevets cités dans la description

- EP 1106709 A2